# EUROPEAN PATENT SPECIFICATION

(11) **EP 2 940 718 B1**
(45) Date of publication and mention of the grant of the patent: **18.04.2018**
(21) Application number: 14166704.8
(22) Date of filing: 30.04.2014
(51) Int. Cl.: H01L 21/50, H01L 23/40, H01L 25/07

(54) **Assembly for cooling a power module**
Anordnung zur Kühlung eines Leistungsmoduls
Ensemble de refroidissement d'un module de puissance

(43) Date of publication of application: 04.11.2015
(73) Proprietor: Vincotech GmbH, 82008 Unterhaching (DE)
(72) Inventor: Pribéli, Tamás, 82008 Unterhaching (DE); Gyimóthy, Zsolt, 82008 Unterhaching (DE)
(74) Representative: Grünecker Patent- und Rechtsanwälte PartG mbB

(56) References cited:
- JP-A- 2010 177 529
- JP-A- 2011 198 817
- US-A- 4 887 149
- US-A1- 2004 217 465
- US-A1- 2013 069 216

## Description

The present invention relates to an assembly for cooling a power module. The power module has a substrate and a cover for covering the substrate, wherein the cover includes a through-hole for tightening the power module to a heat sink in an area that does not overlap with the substrate area. The power module is mounted to the heat sink by means of a single screw, thus ensuring a good thermal contact between substrate and heat sink, although the screw does not go through the middle of the substrate.

In a power module, a multiplicity of discrete electronic components are connected to one another and to at least one module, in which significant power losses occur, on a mount substrate which, for example, may be a direct bonded copper (DBC) substrate. A DBC substrate is composed of a ceramic tile with a sheet of copper bonded to both sides using a high temperature oxidation process. The top copper layer usually forms an electric circuit interconnecting the electronic components of the power module, while the bottom copper layer is usually kept plain. The DBC substrate has good heat spreading characteristics. Therefore, the bottom copper layer of the substrate is normally attached to a heat sink in order to spread the heat generated by the power module.

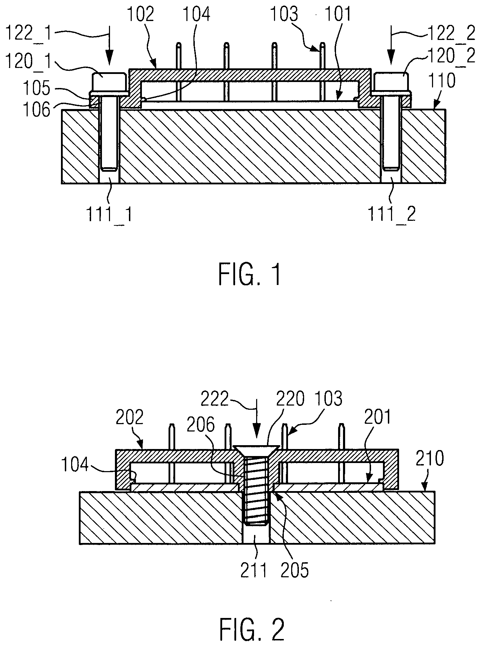

Figure 1 shows a cross sectional view of a first power module according to the prior art, and the way it is mounted on a heat sink. This known power module includes a DBC substrate 101 and a housing/cover 102, which covers the top layer of the DBC substrate 101. The electronic components of the power module, including the module that generates the significant power loss, and electrical connections 103, are mounted on the top layer of the DBC substrate. The housing 102 includes, on its outer side face, two fixing lugs 105, each including a through-hole 106 and, on its inner side face, projections 104. The projections 104 press the DBC substrate 101 against the heat sink 110, so that a good thermal contact exists between the bottom layer of the DBC substrate 101 and the heat sink 110 when the power module is fixed to the heat sink 110.

The first power module, according to the prior art, is fixed to the heat sink 110 by means of two screws 120_1 and 120_2, each being inserted into one of the fixing lugs 105 and screwed into one of the threaded holes 111_1 and 111_2 formed in the heat sink 110. When the two screws 120_1 and 120_2 are tightened in the two threaded holes 111_1 and 111_2 of the heat sink 110, the screws 120_1 and 120_2 exert a pressing force on the housing 102 in the direction indicated by arrows 122_1 and 122_2. The pressing force exerted on the housing 102 presses the bottom surface of the fixing lugs 105 and the bottom layer of the DBC substrate against the heat sink 110.

The first power module, according to the prior art, requires a housing having two fixing lugs, two screws and two threaded holes formed in the heat sink, in order to ensure a good thermal contact between the bottom layer of the DBC substrate and the heat sink. This makes the power module extensive and less suitable for environments with little space. Also, the manufacturing/assembly process of the assembly for cooling the power module is complex. It is, therefore, desirable to have a power module that can be fixed to the heat sink by means of only one screw.

Figure 2 shows the cross sectional view of a second power module, according to the prior art, and the way it is mounted on a heat sink. This power module differs from the first power module, according to the prior art, in that this power module requires only one screw for affixing it to a heat sink. The second power module, according to the prior art, includes a housing/cover 202 covering the top layer of a DBC substrate 201 that does not have fixing lugs at the outer side face of the housing 202, but instead includes a fixing lug 205 in the middle of the housing 202. The DBC substrate 201 of the second power module, according to the prior art, has, in the middle, a through-hole 206 which receives a salient formed at the lower part of the fixing lug 205, thereby making the bottom layer of the DBC substrate 201 coplanar with the bottom surface of the salient.

The second power module, according to the prior art, is fixed to the heat sink 210 by leading a screw 220 through the through-hole 206 of the fixing lug 205, and screwing the screw 220 into a threaded hole 211 formed in the heat sink 210. When the screw 220 is tightened, it exerts a pressing force on the housing 202 in the direction indicated by the arrow 222. This pressing force presses the lower surface of the salient and the bottom layer of the DBC substrate 201 against the heat sink 210.

The power module shown in Figure 2 uses the space more efficiently than the power module shown in Figure 1. However, it requires a through-hole going through the middle of the DBC substrate. Providing a through-hole through the middle of the DBC substrate makes the design of the DBC substrate complex, as it limits the degree of freedom in positioning the electronic components on the DBC substrate, and complicates the routing of the wiring between the individual electronic components. Also, providing a through-hole through the ceramic of the DBC substrate is technically difficult.

Therefore, a power module is needed which avoids the use of a housing with two fixing lugs at its outer side faces, and avoids a DBC substrate having a through-hole in its area.

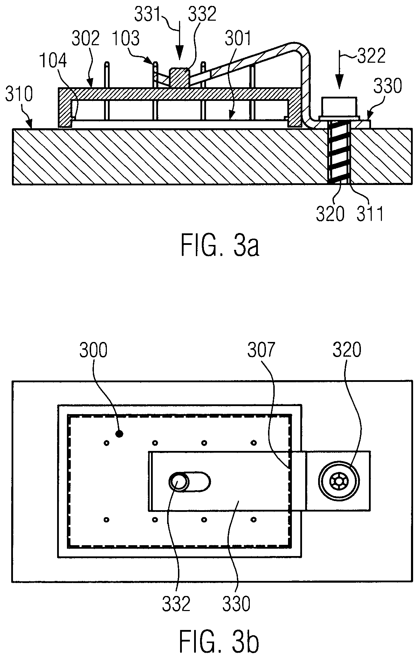

Figure 3a shows a cross sectional view of a third power module, according to the prior art, and the way it is mounted on a heat sink. Figure 3b shows a top view of the third power module 300 according to the prior art. This power module differs from the first power module, according to the prior art, in that this power module requires only one screw for affixing it to the heat sink, and it differs from the second power module in that the screw for affixing it to the heat sink 310 is positioned outside of the substrate area, which is indicated in Figure 3b by rectangle 307. The third power module, according to the prior art, comprises a DBC substrate 301 including, at its top layer, electronic components and electrical connections 103, and a cover/housing 302 covering the top layer of the substrate 301. The housing 302 includes a positioning pin 332 in the middle of its top surface and projections 104 for pressing the bottom layer of the DBC substrate 301 against the heat sink 310, when the third power module 300 is fixed to the heat sink. For affixing the third power module, according to the prior art, to the heat sink 310, a metal spring 330 is needed. The metal spring 330 is S-shaped and includes a first and a second end portion. It is fixed in such a way that it exerts a pressing force on the housing in the direction indicated by arrow 331, when the first end portion of the metal spring 330 engages with the positioning pin 332 on the top surface of the housing 302, and its second end portion is fixed to the heat sink 310. The pressing force exerted on the housing 302 presses the power module 300 against the heat sink 310, so as to make thermal contact between the bottom surface of the DBC substrate 302 and the heat sink 310.

The third power module, according to the prior art, is affixed on the heat sink 310 by means of a screw 320. The screw 320 goes through a through-hole formed at the second end portion of the metal spring 330, and is screwed into a threaded hole 311 formed in the heat sink 310. When the screw 320 is tightened, it exerts a pressing force on the second end portion of the metal spring 330 in the direction indicated by arrow 322. This pressing force presses the second end portion of the metal spring 330 against the heat sink 310, thereby tensioning the metal spring 330 in such a way that its first end portion exerts a pressing force in the direction indicated by arrow 331.

The third power module, according to the prior art, does not require a through-hole in the area of the DBC substrate, and a fixing lug formed on the inner top surface of the housing, for pressing the power module against the heat sink. Instead, the third power module, according to the prior art, needs an adequately tensioned metal spring. However, it is difficult to mount this on the heat sink by means of a screw. Also, due to the curvature of the metal spring, the assembly formed by the power module, the heat sink and the metal spring is extensive in its height.

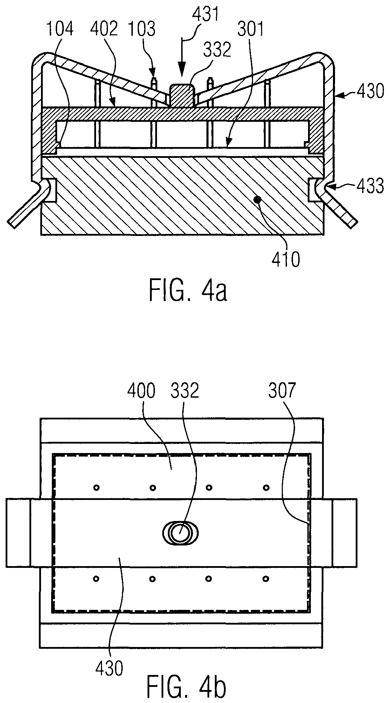

Figure 4a shows a cross sectional view of a fourth power module, according to the prior art, and the way it is mounted on a heat sink. Figure 4b shows a top view of the fourth power module 400, according to the prior art. The housing 402 of this power module is affixed to the heat sink 410 by means of a M-shaped metal spring 430, including, at the end of each side, a spring clip 433. For affixing the fourth power module 400, according to the prior art, to the heat sink 410, the spring clips 433 are engaged with corresponding cut outs formed at opposite side faces of the heat sink 410. When the spring clips 433 of the metal spring 430 engage with the cut outs formed on the side faces of the heat sink 410, the metal spring 430 exerts a pressing force on the power module 400 in the direction indicated by an arrow 431. This pressing force presses the DBC substrate 301 of the power module 400 against the heat sink 410.

The power module shown in Figures 4a and 4b can be more easily mounted to the heat sink than the power module shown in Figures 3a and 3b, as the mount requires only engaging the spring clips 433 with the cut outs of the heat sink. However, as the cut outs need to be formed at the side faces of the heat sink, the M-shaped metal spring must embrace the whole heat sink. This makes the assembly formed by the power module and the heat sink quite extensive.

US 4887149 discloses a package for semiconductor devices provided with an encased metallic heat sink, wherein an encapsulating body of the resin extends beyond the perimeter of the heat sink to form two side extensions, diametrically opposite with respect to a center portion of the body. Two fastening points are provided in the lateral extensions. Two fastening screws received in both fastening points, and screwed down into suitably threaded holes formed in an external heat sink, secure the package on the latter.

US 2004/0217465 A1 discloses a semiconductor power module comprising at least a substrate including at least a semiconductor element and a pressing device which acts on the substrate. The pressing device enables to press the substrate on a cooling element so as to evacuate from semiconductor components operational heat losses. The pressing device is mounted on the cooling element by means of two mounting screws.

### SUMMARY OF INVENTION

It is therefore, an objective of the present invention to provide an assembly for cooling a power module, wherein the power module can be fixed to a heat sink by means of only one screw that is positioned in an area that does not overlap the area of the power module's substrate.

This objective is achieved by the features as set forth in claims 1 and 2. Further, advantageous embodiments of the present invention are set forth in the dependent claims.

The present invention is based on the idea that the cover/housing of the power module is formed into one piece and includes: a first part covering at least a part of the power module's substrate, and a second part connected to the first part and disposed in area that does not overlap with the area of the substrate, wherein the substrate is adhered to a lower portion of the first part of the cover with a flexible glue, the lower portion of the second part of the cover includes a base, which includes a protrusion at its lower surface and a through-hole disposed between the protrusion and the first part of the cover. Good thermal contact between the substrate of the power module and a heat sink is achieved, when the power module is tightened to the heat sink by means of a single screw that goes through the through-hole of the base.

The power module, according to the present invention, provides the following advantages: it does not need a fixing hole in the area of the substrate; it has a simple packaging; it can be easily assembled; it can be easily mounted on the customer's side; and it does not need much space.

### BRIEF DESCRIPTION OF DRAWINGS

- **Fig. 1**: shows a cross sectional view of a first power module, according to the prior art, mounted on a heat sink;
- **Fig. 2**: shows a cross sectional view of a second power module, according to the prior art, mounted on a heat sink;
- **Fig. 3a**: shows a cross sectional view of a third power module, according to the prior art, mounted on a heat sink;
- **Fig. 3b**: shows a top view of the third power module, according to the prior art, mounted on a heat sink;
- **Fig. 4a**: shows a cross sectional view of a fourth power module, according to the prior art, mounted on a heat sink;
- **Fig. 4b**: shows a top view of the fourth power module, according to the prior art, mounted on a heat sink;
- **Fig. 5a**: shows a top view of an assembly for cooling a power module, according to a first embodiment of the present invention;
- **Fig. 5b**: shows a cross sectional view of the an assembly for cooling a power module, according to the first embodiment of the present invention, in a state where a screw does not apply a pressing force on the power module;
- **Fig. 5c**: shows a cross sectional view of the assembly for cooling a power module, according to the first embodiment of the present invention, in a state where the screw applies a pressing force on the power module;
- **Fig. 6a**: shows a top view of an assembly for cooling a power module, according to a second embodiment of the present invention;
- **Fig. 6b**: shows a cross sectional view of the assembly for cooling a power module, according to the second embodiment of the present invention, in a state where a screw does not apply a pressing force on the power module;
- **Fig. 6c**: shows a cross sectional view of the assembly for cooling a power module, according to the second embodiment of the present invention, in a state where the screw applies a pressing force on the power module;

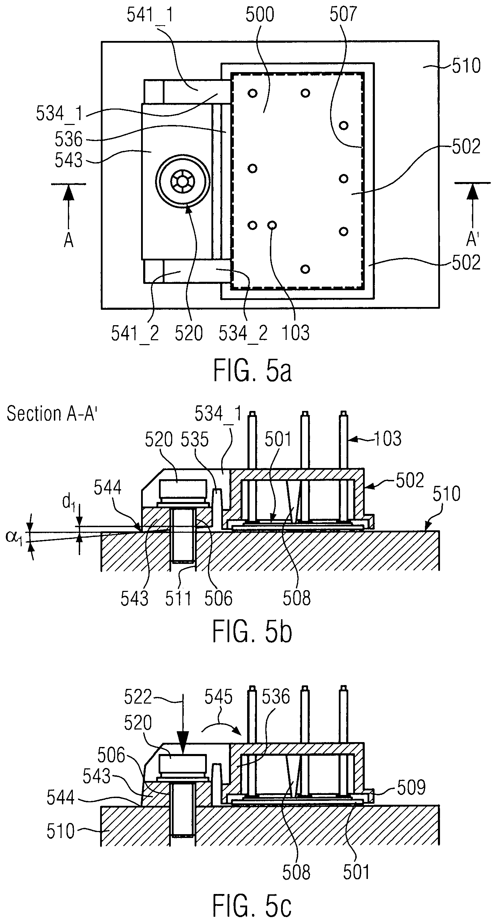

Referring now to Figs. 5a to 5c, an assembly for cooling a power module, according to a first embodiment of the present invention, is shown. The figures also show how the power module is mounted on a heat sink.

Fig. 5a shows the top view of the power module, according to the first embodiment. The power module 500, according to the first embodiment, includes a substrate 501, preferably a DBC substrate, and a cover/housing that covers at least a part of the upper surface of the substrate 501. The substrate 501 has, on its upper surface, electronic components, electric circuitry interconnecting the individual electronic components, and electrical connections 103 which protrude outwards from the cover. The electronic components include at least one module that generates power loss/heat. The heat has to be diverted, when the power module is in operation. In order to dissipate the heat, the power module 500, according to the first embodiment, is mounted on a heat sink 510 by means of a screw 520, so that the bottom surface of the substrate 501 attaches an upper surface of the heat sink 510. Preferably, the bottom surface of the substrate 501 and the upper surface of the heat sink are even.

In the first embodiment of the present invention, the substrate 501 has a substantially rectangular form, and the part of the cover covering at least a part of the upper surface of the substrate has the form of a rectangular parallelepiped. However, the present invention is not limited to a rectangular shape. The part of the cover covering at least a part of the upper surface of the substrate 501, which is also denoted as the first part 502 of the cover, includes four side walls and a flat roof covering the upper surface of the substrate 501 or at least a part of it. The dashed line 507 indicates the margin of the substrate 501.

For mounting the power module, according to the first embodiment, to the heat sink 510, the power module 500 includes a base 543, which is connected to a first side wall 536 of the first part 502 of the cover by means of first and second connection parts 541_1 and 541_2. The base 543 includes a through-hole 506 for inserting the screw 520 for mounting the power module 500 to the heat sink 510. In Fig. 5a, the base has a substantially rectangular form and the two connection parts 541_1 and 541_2 connecting the base 543 to the first side wall 536 of the first part 502 of the cover are disposed at opposing ends of the base 543. However, the present invention is not limited to this structure, but also relates to a structure wherein the first and second connection parts are not disposed at the ends of the base 543. The present invention also may relate to a structure wherein the base has a triangular or trapezoidal form and is connected to the first side wall by means of only one connection part. For convenience, the structure including the base 543, the first connection part 541_1 and the second connection part 541_2 is denoted as the second part of the cover.

In the present invention, the cover, including the first part 502 and the second part, is formed in one piece, preferably of plastic material. Furthermore, it is essential for the present invention that the second part of the cover is disposed in an area that does not overlap with the area of the substrate 501. In particular, it is important that the screw 520 for mounting the power module 500 to the heat sink 510 is outside of the area of the substrate 510.

A cross-sectional view of the power module, according to the first embodiment, at section A - A' in Fig. 5a, in a state where the screw 520 is not tightened and the power module 500 is not pressed to the upper surface of the heat sink 510, is shown in Fig. 5b. Section A - A' goes through the middle of the screw 520 and is perpendicular to the first side wall 536 of the first part 502 of the cover. Fig. 5b shows that the substrate 501 is arranged at a lower portion of the first part 502 of the cover. In the present invention, the substrate 501 is adhered to the first part 502 by means of flexible glue. Preferably, a part of the upper surface of the substrate 501 is adhered to a lower end/rim of the first part 502 of the cover, so that the first part 502 of the cover presses the substrate 501 toward the heat sink 510, when a pressing force is exerted against the first part 502 in a downward direction. In Figs. 5a and 5b, the lower rim of the first part 502 of the cover is constituted by the lower ends of the four side walls, and the margin of the substrate 501 is adhered to the lower rim. Preferably, the rim of the first part 502 includes a rabbet 509 and the margin of the substrate 501, which is adhered to a side or a lower surface of the rabbet 509, engages with the rabbet 509.

Fig. 5b further shows that the lower surface of the substrate 501 protrudes slightly from the lower/lowest surface of the rabbet 509, so as to enable good thermal contact with the heat sink 510, when the power module 500 is mounted to the heat sink 510. The thermal contact between the substrate 501 and the heat sink 510 can be further enhanced by means of one or more pillars 508 projecting from the flat roof of the first part 502 of the cover towards the substrate 501, and contacting with the upper surface of the substrate 501.

In the power module, according to the first embodiment, the first connection part 541_1 and the second connection part 541_2 include a first bridge 534_1 and a second bridge 534_2, respectively. The first bridge 534_1 connects the upper portion of the first connection part 541_1 to the upper portion of the first side wall 536 of the first part 502 of the cover, and the second bridge 534_2 connects the upper portion of the second connection part 541_2 to the upper portion of the first side wall 536 of the first part 502 of the cover, so that a first recess 535 is formed between the lower portion of the first connection part 541_1 and the first side wall 536 of the first part 502, and a second recess is formed between the lower portion of the second connection part 541_2 and the first side wall 536 of the first part 502. The structure of the first connection part 541_1 including the first bridge 534_1, and the first recess 535 are shown in Fig. 5b.

The base 543, which forms the lower portion of the second part of the cover, is connected to the first and second connection parts 541_1 and 541_2 at respective portions of its upper surface. In the power module 500, according to the first embodiment, the upper surface of the base 543, the lower surface of the base 543, and the side surfaces of the base 543 have a substantially rectangular form. Opposing side faces of the base 543 are parallel to each other. However, the upper surface and the lower surface of the base 543 are tapered to each other. The length of the base 543 is parallel to the first side wall 536 of the first part 502 of the cover, and the base 543 is connected to the first and second connection parts 541_1 and 541_2 at portions that oppose each other the length of the base 543. Preferably, the upper surface of the base 543 is even, and the plane, including the upper surface of the base 543, is parallel to the plane including the lower surface of the substrate 501. The lower surface of the base 543 of the power module 500, according to the first embodiment, is even and slanted by an angle α₁ relative to the plane including the lower surface of the substrate 501, so that the height of the side surface of the base 543, which is further from the first side wall 536 of the first part 502, is greater than the height of the side surface of the base 543, which is nearest to the first side wall 536 of the first part 502 of the cover. In other words, the lower surface of the base 543 is slanted towards an upper portion of the first part 502 of the cover.

According to the first embodiment, the lower surface of the base 543 and the side surface of the base 543, which is more distant from the first side wall 536 of the first part 502 of the cover, form an edge 544 which extends the length of the base 543, from one end of the base 543 to the other end of the base 543. This edge is linear and parallel to the first side wall 536 of the first part 502 of the cover, and is also denoted as the edge 544 of the lower surface of the base 543, which is more distant from the first part 502 of the cover. The lower surface of the base 543 and the side surface of the base 543 being nearest to the first side wall 536 of the first part 502 of the cover, form an edge which is parallel to the edge 544 of the lower surface of the base 543, which is more distant from the first part 502 of the cover.

The edge 544 of the lower surface of the base 543, which is more distant from the first part 502 of the cover, and the lower surface of the substrate 501 are (substantially) coplanar. The through-hole 506 formed in the base 543 extends from the upper surface of the base 543 to the lower surface of the base 543. In length direction, the through-hole 506 is preferably positioned at equal distances from the one end of the base 543 and from the other end of the base 543. Furthermore, the through-hole 506 is positioned between the edge 544 of the lower surface of the base, that is more distant from the first part 502 of the cover, and the edge of the lower surface of the base 543, that is nearest to the first part 502 of the cover. This arrangement allows the power module 500, according to the first embodiment, to act as a lever of (class 3), when the power module is fixed onto the heat sink 510. The lever, which is formed by the cover of the power module 500, pivots at the edge 544 of the lower surface of the base 543, which is more distant from the first part 502 of the cover, so as to press the lower surface of substrate 501 against the heat sink 510, when the screw 520 is tightened into the threaded hole 511 provided on the upper surface of the heat sink 510.

Fig. 5c shows a cross-sectional view of the power module 500, according to the first embodiment, at section A - A', in a state where the screw 520 is tightened into the threaded hole 511 of the heat sink 510. In this state, the screw 520 applies a screw down force 522 to the base 543, which presses the base 543 towards the upper surface of the heat sink 510. At a final state, when the screw down force 522 achieves a predetermined value (strength), the whole lower surface of the base 543, including the edge of the lower surface of the base 543, which is nearest to the first part 502 of the cover, is in contact with the upper surface of the heat sink 510. The screw down force 522 applied by the screw 520 to the base 543 induces a rotation 545 of the second part of the cover around the fulcrum formed by the edge 544 of the lower surface of the base 543, that is more distant from the first part 502 of the cover. This rotation induces a strain in the first and second bridges 541_1 and 541_2, which exerts a pressing force onto the substrate 501. This pressing force presses the substrate 501 to the heat sink 510, thereby enhancing the thermal contact between the lower surface of the substrate 501 and the heat sink 510.

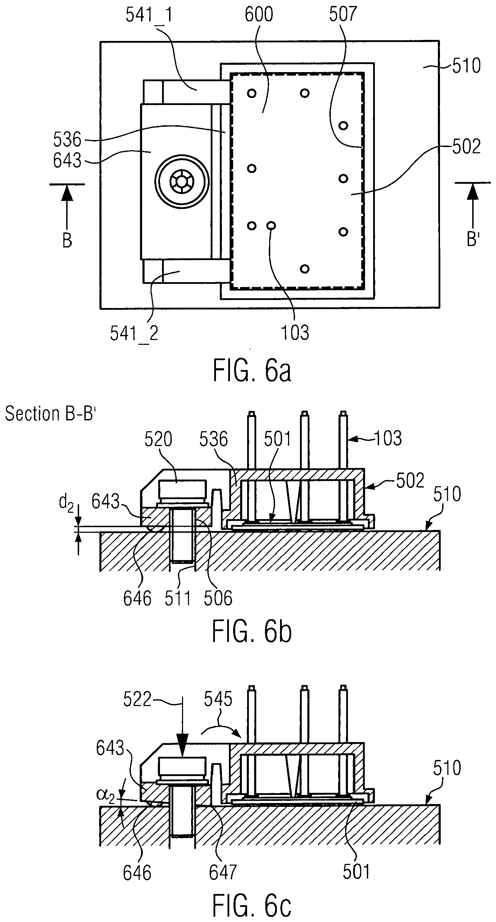

Referring now to Figs. 6a to 6c, an assembly for cooling a power module, according to a second embodiment of the present invention, is shown. The figures also show how the power module is mounted on a heat sink.

Fig. 6a shows the top view of the power module, according to the second embodiment. The power module 600, according to the second embodiment, has essentially the same structure as the power module 500, according to the first embodiment. However, the power module 600, according to the second embodiment, differs from the power module 500, according to the first embodiment, in the structure of the base 643, which is connected to the first side wall 536 of the first part 502 of the cover by means of the first and second connection parts 541_1 and 541_2. For convenience, the description of the parts of the power module 600, according to the second embodiment, that have the same structure as the power module 500, according to the first embodiment, has been omitted, and only the differentiating parts/features of the power module 600 are described in the following.

A cross sectional view of the power module 600, according to the second embodiment, at section B - B' in Fig. 6a, in a state where the power module 600 is not pressed to the upper surface of the heat sink 510, is shown in Fig. 6b. Section B - B' goes through the middle of the screw 520 for mounting the power module 600 onto the heat sink 510, and is perpendicular to the first side wall 536 of the first part 502 of the cover.

In the second embodiment, the base 643 has essentially the form of a rectangular parallelepiped and includes, at its lower surface, a protrusion 646 projecting from the lower surface of the heat sink 510 in a downward direction by a length d2. The lower surface of the base 643 is the surface that faces the upper surface of the heat sink 510, when the power module 600 is provided onto the upper surface of the heat sink.

The length d2 is selected in such a way that the lower surface of the substrate 501 and the lower end of the protrusion 646 are coplanar.

The protrusion 646 provided on the lower surface of the base 643 is linear, parallel to the first side wall 536 and extends the length of the base 643, from one end of the base 643 to the other end of the base 643. The through hole 506 formed in the base 643, which extends from the upper surface of the base 643 to the lower surface of the base 643, is positioned between the protrusion 646 and the edge of the lower surface of the base 643, which is nearest to the first part 502 of the cover. This arrangement permits the power module 600, according to the second embodiment, to act as a lever (of class 3) when the power module 600 is fixed onto the heat sink 510. The lever, which is formed by the cover of the power module 600, pivots around the protrusion 644 provided on the lower surface of the base 643, and presses the lower surface of substrate 501 against the heat sink 510 when the screw 520 is tightened into the threaded hole 511 provided in the heat sink 510.

Fig. 6c shows a cross sectional view of the power module 600, according to the second embodiment, at Section B - B', in a state where the screw 520 is tightened into the threaded hole of the heat sink 510. In this state, the screw 520 applies a screw down force 522 to the base 643, which presses the base 643 towards the upper surface of the heat sink 510. At a final state, when the screw down force 522 achieves a predetermined value (strength), the edge 647 of the lower surface of the base 643, which is nearest to the first part 502 of the cover, is in contact with the upper surface of the heat sink 510, and the lower surface of the base 643 forms an angle α₂ with the upper surface of the heat sink 510. The screw down force 522 applied by the screw 520 to the base 643 exerts, via the first and second connection parts 541_1 and 541_2 and via the first and second bridges 534_1 and 534_2, a pressing force onto the substrate 501. This pressing force presses the substrate 501 to the heat sink 510, thereby enhancing the thermal contact between the substrate 501 and the heat sink 510.

An assembly for cooling a power module, according to the present invention, comprises: a heat sink 510 having a threaded hole 511 formed on its upper surface; a power module, 500 (or 600), which is provided on the upper surface of the heat sink 510 in such a way that one of the protrusion 544 and 646 provided on the lower surface of the base and the lower surface of the substrate contact the upper surface of the heat sink; and a screw 520 going through the through-hole 506 of the base and tightened in the threaded hole 511 of the heat sink 510, thereby applying a screw down force onto the base 543, 643.

According to the present invention, the power module 500 (or 600) can be fixed to the heat sink 510 by means of only one screw 520, which is positioned in an area that does not overlap with the area of the substrate 501. Therefore, the present invention provides the following advantages: it does not need a fixing hole in the area of the substrate; it has a simple packaging; it can be easily assembled; it can be easily mounted on the customer's side; and it does not need much space.

**Reference Numerals**

| **Reference Numerals** | **Description** |
|---|---|
| 101, 201, 301, 501 | Substrate |
| 102, 202, 302, 402, 502 | Plastic housing |
| 103 | Electrical connector |
| 104 | Pressuring projection |
| 105, 205 | Fixing lug |
| 106, 206, 506 | Through-hole |
| 110, 210, 310, 410, 510 | Heat sink |
| 111_1, 111_2, 211, 311, 511 | Threaded hole in heat sink |
| 120_1, 120_2, 220, 320, 520 | Screw |
| 122_1, 122_2, 222, 322, 522 | Arrow indicating the force applied by the screw on the plastic housing |
| 300, 400, 500, 600 | Power module |
| 307, 507 | Margin of the substrate area |
| 330, 430 | Metal spring |
| 331, 431 | Arrow indicating the force exerted by the metal spring on the plastic housing |
| 332 | Positioning pin |
| 433 | Spring clip |
| 508 | Pillar |
| 509 | Notch/Rabbet |
| 534_1, 534_2 | Bridge |
| 535 | Recess |
| 536 | First side wall |
| 541_1, 541_2 | Connection parts |
| 543, 643 | Base |
| 544 | Far Edge |
| 545 | Arrow indicating the transition of the pressing force from the screw to the housing |
| 646 | Protrusion |
| 647 | Near Edge |
| | |

## Claims

1. An assembly for cooling a power module, including:
a heat sink (510) with a threaded hole (511) formed on its upper surface;
a power module (600) provided on the upper surface of the heat sink (510); and
a screw (520);
wherein the power module (600), comprises:
a substrate (501) including an electrical circuit;
a cover formed into one piece, including a first part (502) and a second part,
wherein the first part (502) covers at least a part of the substrate (501),
the second part is connected to the first part (502) and disposed in an area that does not overlap with the substrate (501),
the second part of the cover includes a lower portion having a base (643) with an upper surface and a lower surface,
the base (643) includes a through-hole (506) which is directed from the upper surface of the base (643) to the lower surface of the base,
the screw (520) passes through the through-hole (506) of the base (643) and is screwed in the threaded hole (511) of the heat sink (510) so that the screw down force applied by the screw (520) on the base (643) exerts a pressing force onto the substrate and ensures thermal contact between the substrate (501) and the heat sink (510), and
the lower surface of the substrate (501) is in contact with the upper surface of the heat sink (510),
**characterized in that**
a part of the upper surface of the substrate (501) is adhered to a lower portion of the first part (502) of the cover with a flexible glue,
the base (643) includes a protrusion (646) at its lower surface,
the through-hole (506) is disposed between the protrusion (646) and the first part (502) of the cover,
the protrusion (646) on the lower surface of the base (643) is in contact with the upper surface of the heat sink (510),
the second part of the cover includes a bridge (534_1) connecting an upper portion of the second part of the cover and an upper portion of the first part (502) of the cover, and
the screw (520) passing through the through-hole (506) and screwed in the threaded hole (511) is the single screw that fixes the power module (500) to the heat sink (510).

2. An assembly for cooling a power module, including:
a heat sink (510) with a threaded hole (511) formed on its upper surface;
a power module provided on the upper surface of the heat sink (510); and
a screw (520);
wherein the power module (500), comprises:
a substrate (501) including an electrical circuit;
a cover formed into one piece, including a first part (502) and a second part,
wherein the first part (502) covers at least a part of the substrate (501),
the second part is connected to the first part (502) and disposed in an area that does not overlap with the substrate (501),
the second part of the cover includes a lower portion having a base (543) with an upper surface and a lower surface,
the base (543) includes a through-hole (506) which is directed from the upper surface of the base (543) to the lower surface of the base,
the screw (520) passes through the through-hole (506) of the base (543) and is screwed in the threaded hole (511) of the heat sink (510), so that the screw down force applied by the screw (520) on the base (543) exerts a pressing force onto the substrate and ensures thermal contact between the substrate (501) and the heat sink (510), and
the lower surface of the substrate (501) is in contact with the upper surface of the heat sink (510),
**characterized in that**
a part of the upper surface of the substrate (501) is adhered to a lower portion of the first part (502) of the cover with a flexible glue,
the lower surface of the base (543) is even and slanted towards an upper portion of the first part (502) of the cover,
the through-hole (506) is disposed between the first part (502) of the cover and the edge (544) of the lower surface of the base (543), that is more distant from the first part (502) of the cover,
the edge (544) of the lower surface of the base (543), that is more distant from the first part (502) of the cover, is in contact with the upper surface of the heat sink (510),
the second part of the cover includes a bridge (534_1) connecting an upper portion of the second part of the cover and an upper portion of the first part (502) of the cover, and
the screw (520) passing through the through-hole (506) and screwed in the threaded hole (511) is the single screw that fixes the power module (500) to the heat sink (510).

3. The assembly according to claim 2, wherein the height of the side surface of the base (543), which is further from the first part (502) of the cover, is greater than the height of the side surface of the base (543), which is nearest to the first part (502) of the cover.

4. The assembly according to claim 1, wherein the upper surface of the base (543, 643) is even and parallel with the lower surface of the base.

5. The assembly according to any of claims 1 to 4, wherein the lower surface of the substrate (501) and the lower end of the protrusion (646) provided on the lower surface of the base (643) are coplanar, or the lower surface of the substrate (501) and the edge (544) of the lower surface of the base (543), that is more distant from the first part (502) of the cover, are coplanar.

6. The assembly according to any of claims 1 to 5, wherein a recess (535) is formed between the first part (502) of the cover and the second part of the cover.

7. The assembly according to any of claims 1 to 6, wherein the substrate (501) is a direct bonded copper (DBC) substrate.

8. The assembly according to any of claims 1 to 7, wherein the lower portion of the first part (502) of the cover includes a rim, and
a part of the upper surface of the substrate (501) is adhered to a lower surface of the rim.

9. The assembly according to claim 8, wherein the rim includes a rabbet (509),
a part of the upper surface of the substrate (501) is adhered to a side of the rabbet (509), and the lower surface of the substrate (501) protrudes from a lower surface of the rabbet (509).

10. The assembly according to any of claims 1 to 9, wherein the substrate (501) has a substantially rectangular form,
the first part (502) of the cover substantially has the form of a rectangular parallelepiped and includes four side walls and a flat roof disposed above the substrate (501),
the rim of the first part (502) of the cover is formed by the lower ends of the four side walls,
the part of the upper surface of the substrate (501) which is adhered to a lower surface of the rim is a peripheral area of the upper surface of the substrate,
the protrusion (646) provided on the lower surface of the base or the edge (544) of the lower surface of the base (543), that is more distant from the first part (502) of the cover, is linear, parallel and nearest to a first side wall (536) of the four side walls of the first part (502) of the cover,
the second part of the cover includes a first connection part (541_1) and a second connection part (541_2) connecting the base (543, 643) to the first part (502) of the cover,
the first connection part (541_1) and the second connection part (541_2) are connected to the first side wall (536), and
the through-hole (506) is disposed between the first connection part (541_1) and the second connection part (541_2).

11. The assembly according to claim 10, wherein the first connection part (541_1) includes a first bridge (534_1) connecting the first connecting part (541_1) to the first side wall (536), so that a first recess (535) is formed between the first connection part (541_1) and the first side wall (536), and/or
the second connection part (541_2) includes a second bridge (534_2) connecting the second connecting part (541_2) to the first side wall (536), so that a second recess is formed between the second connection part (541_2) and the first side wall (536).

12. The assembly according to claim 10 or 11, wherein the protrusion (646) provided on the lower surface of the base (643) or the edge (544) of the lower surface of the base (543), that is more distant from the first part (502) of the cover, extends from a first end of the base to a second end of the base, which is opposite to the first end of the base,
the first connection part (541_1) is connected to the base (543, 643) at its first end, and/or
the second connection part (541_2) is connected to the base (543, 643) at its second end.

13. The assembly according to claim 12, wherein a pillar (508) projects from the flat roof towards the inner of the first part (502) of the cover and contacts a part of the upper surface of the substrate (501).

14. The assembly according to any of the claims 1 to 13, wherein the substrate (501) includes a semiconductor circuit.

15. The assembly according to any of claims 1 to 14, wherein the edge (647) of the lower surface of the base (643) that is nearest to the first part (502) of the cover contacts the upper surface of the heat sink (501).

## Patentansprüche

1. Anordnung zum Kühlen eines Leistungsmoduls, mit:
einer Wärmesenke (510) mit einer Gewindebohrung (511), die auf ihrer oberen Oberfläche ausgebildet ist;
einem Leistungsmodul (600), das auf der oberen Oberfläche der Wärmesenke (510) vorgesehen ist; und
einer Schraube (520);
wobei das Leistungsmodul (600) umfasst:
ein Substrat (501) mit einer elektrischen Schaltung;
eine Abdeckung, die als ein Stück gebildet ist, mit einem ersten Teil (502) und einem zweiten Teil, wobei
der erste Teil (502) zumindest einen Teil des Substrats (501) abdeckt, der zweite Teil mit dem ersten Teil (502) verbunden und in einem Bereich angeordnet ist, der mit dem Substrat (501) nicht überlappt,
wobei der zweite Teil der Abdeckung einen unteren Teilbereich mit einem Basiselement (643) mit einer oberen Oberfläche und einer unteren Oberfläche aufweist,
das Basiselement (643) ein Durchgangsloch (506) aufweist, das von der oberen Oberfläche des Basiselements (643) zu der unteren Oberfläche des Basiselements gerichtet ist,
die Schraube (520) durch das Durchgangsloch (506) des Basiselements (643) verläuft und in der Gewindebohrung (511) der Wärmesenke (510) verschraubt ist, so dass die Schraubenandruckskraft, die von der Schraube (520) auf das Basiselement (643) ausgeübt wird, einen Wärmekontakt zwischen dem Substrat (501) und der Wärmesenke (510) gewährleistet, und
die untere Oberfläche des Substrats (501) mit der oberen Oberfläche der Wärmesenke (510) in Kontakt ist,
**dadurch gekennzeichnet, dass**
ein Teil der oberen Oberfläche des Substrats (501) an einem unteren Teilbereich des ersten Teils (502) der Abdeckung mittels eines flexiblen Klebemittels haftet,
das Basiselement (643) einen Vorsprung (646) auf seiner unteren Oberfläche aufweist,
das Durchgangsloch (506) zwischen dem Vorsprung (646) und dem ersten Teil (502) der Abdeckung angeordnet ist,
der Vorsprung (646) auf der unteren Oberfläche des Basiselements (643) mit der oberen Oberfläche der Wärmesenke (510) in Kontakt ist,
der zweite Teil der Abdeckung eine Brücke (534_1), die einen oberen Teilbereich des zweiten Teils der Abdeckung und einen oberen Teilbereich des ersten Teils (502) der Abdeckung verbindet, aufweist, und
die Schraube (520), die durch das Durchgangsloch (506) verläuft und in der Gewindebohrung (511) verschraubt ist, die einzige Schraube ist, die das Leistungsmodul (500) an der Wärmesenke (510) befestigt.

2. Anordnung zum Kühlen eines Leistungsmoduls, mit:
einer Wärmesenke (510) mit einer Gewindebohrung (511), die auf ihrer oberen Oberfläche ausgebildet ist;
einem Leistungsmodul, das auf der oberen Oberfläche der Wärmesenke (510) vorgesehen ist; und
einer Schraube (520);
wobei das Leistungsmodul (500) umfasst:
ein Substrat (501) mit einer elektrischen Schaltung;
eine Abdeckung, die als ein Stück gebildet ist, mit einem ersten Teil (502) und einem zweiten Teil, wobei
der erste Teil (502) zumindest einen Teil des Substrats (501) abdeckt,
der zweite Teil mit dem ersten Teil (502) verbunden und in einem Bereich angeordnet ist, der mit dem Substrat (501) nicht überlappt,
der untere Teilbereich des zweiten Teils der Abdeckung ein Basiselement (543) mit einer oberen Oberfläche und einer unteren Oberfläche aufweist, das Basiselement (543) ein Durchgangsloch (506) aufweist, das von der oberen Oberfläche des Basiselements (543) zu der unteren Oberfläche des Basiselements gerichtet ist,
die Schraube (520) durch das Durchgangsloch (506) des Basiselements (543) verläuft und in der Gewindebohrung (511) der Wärmesenke (510) verschraubt ist, so dass die Schraubenandruckskraft, die von der Schraube (520) auf das Basiselement (543) ausgeübt wird, einen Wärmekontakt zwischen dem Substrat (501) und der Wärmesenke (510) gewährleistet, und
die untere Oberfläche des Substrats (501) mit der oberen Oberfläche der Wärmesenke (510) in Kontakt ist,
**dadurch gekennzeichnet, dass**
ein Teil der oberen Oberfläche des Substrats (501) an einem unteren Teilbereich des ersten Teils (502) der Abdeckung mittels eines flexiblen Klebemittels haftet,
die untere Oberfläche des Basiselements (543) eben und einseitig in Richtung auf einen oberen Teilbereich des ersten Teils (502) der Abdeckung ausgerichtet ist,
das Durchgangsloch (506) zwischen dem ersten Teil (502) der Abdeckung und der Kante (544) der unteren Oberfläche des Basiselements (543), die weiter von dem ersten Teil (502) der Abdeckung entfernt ist, angeordnet ist,
die Kante (544) der unteren Oberfläche des Basiselements (543), die weiter von dem ersten Teil (502) der Abdeckung entfernt ist, mit der oberen Oberfläche der Wärmesenke (510) in Kontakt ist,
der zweite Teil der Abdeckung eine Brücke (534_1) aufweist, die einen oberen Teilbereich des zweiten Teils der Abdeckung und einen oberen Teilbereich des ersten Teils (502) der Abdeckung verbindet, und
die Schraube (520), die durch das Durchgangsloch (506) verläuft und in der Gewindebohrung (511) verschraubt ist, die einzige Schraube ist, die das Leistungsmodul (500) an der Wärmesenke (510) befestigt.

3. Anordnung nach Anspruch 2, wobei die Höhe der Seitenfläche des Basiselements (543), die weiter von dem ersten Teil (502) der Abdeckung entfernt ist, größer ist als die Höhe der Seitenfläche des Basiselements (543), die dem ersten Teil (502) der Abdeckung am nächsten liegt.

4. Anordnung nach Anspruch 1, wobei die obere Oberfläche des Basiselements (543, 643) geben und parallel zu der unteren Oberfläche des Basiselements ist.

5. Anordnung nach einem der Ansprüche 1 bis 4, wobei die untere Oberfläche des Substrats (501) und das untere Ende des Vorsprungs (646), der auf der unteren Oberfläche des Basiselements (643) vorgesehen ist, planparallel sind, oder die untere Oberfläche des Substrats (501) und die Kante (544) der unteren Oberfläche des Basiselements (543), die weiter von dem ersten Teil (502) der Abdeckung entfernt ist, planparallel sind.

6. Anordnung nach einem der Ansprüche 1 bis 5, wobei eine Vertiefung (535) zwischen dem ersten Teil (502) der Abdeckung und dem zweiten Teil der Abdeckung ausgebildet ist.

7. Anordnung nach einem der Ansprüche 1 bis 6, wobei das Substrat (501) ein direkt gebondetes Kupfer- (DBC) Substrat ist.

8. Anordnung nach einem der Ansprüche 1 bis 7, wobei der untere Teilbereich des ersten Teils (502) der Abdeckung einen Rand aufweist, und
ein Teil der oberen Oberfläche des Substrats (501) an einer unteren Oberfläche des Rands haftet.

9. Anordnung nach Anspruch 8, wobei der Rand eine Fuge (509) aufweist,
ein Teil der oberen Oberfläche des Substrats (501) an einer Seite der Fuge (509) haftet, und
die untere Oberfläche des Substrats (501) aus einer unteren Oberfläche der Fuge (509) hervorsteht.

10. Anordnung nach einem der Ansprüche 1 bis 9, wobei das Substrat (501) eine im Wesentlichen rechteckige Form hat, der erste Teil (502) der Abdeckung im Wesentlichen die Form eines rechteckigen Parallelepipeds hat und vier Seitenwände und ein flaches Dach, das über dem Substrat (501) angeordnet ist, aufweist, der Rand des ersten Teils (502) der Abdeckung durch die unteren Enden der vier Seitenwände gebildet ist,
der Teil der oberen Oberfläche des Substrats (501), der an einer unteren Oberfläche des Rands haftet, ein peripherer Bereich der oberen Oberfläche des Substrats ist,
der Vorsprung (646), der an der unteren Oberfläche des Basiselements oder der Kante (544) der unteren Oberfläche des Basiselements (543), die weiter von dem ersten Teil (502) der Abdeckung entfernt ist, vorgesehen ist, geradlinig, parallel und nächstliegend zu einer ersten Seitenwand (536) der vier Seitenwände des ersten Teils (502) der Abdeckung ist,
der zweite Teil der Abdeckung einen ersten Verbindungsteil (541_1) und einen zweiten Verbindungsteil (541_2), der das Basiselement (543, 643) mit dem ersten Teil (502) der Abdeckung verbindet, aufweist,
der erste Verbindungsteil (541_1) und der zweite Verbindungsteil (541_2) mit der ersten Seitenwand (536) verbunden sind, und
das Durchgangsloch (506) zwischen dem ersten Verbindungsteil (541_1) und dem zweiten Verbindungsteil (541_2) angeordnet ist.

11. Anordnung nach Anspruch 10, wobei der erste Verbindungsteil (541_1) eine erste Brücke (534_1), die den ersten Verbindungsteil (541_1) mit der ersten Seitenwand (536) verbindet, aufweist, so dass eine erste Vertiefung (535) zwischen dem ersten Verbindungsteil (541_1) und der ersten Seitenwand (536) gebildet ist, und/oder
der zweite Verbindungsteil (541_2) eine zweite Brücke (534_2), die den zweiten Verbindungsteil (541_2) mit der ersten Seitenwand (536) verbindet, aufweist, so dass eine zweite Vertiefung zwischen dem zweiten Verbindungsteil (541_2) und der ersten Seitenwand (536) gebildet ist.

12. Anordnung nach Anspruch 10 oder 11, wobei der Vorsprung (646), der an der unteren Oberfläche des Basiselements (643) oder der Kante (544) der unteren Oberfläche des Basiselements (543), die weiter von dem ersten Teil (502) der Abdeckung entfernt ist, vorgesehen ist, sich von einem ersten Ende des Basiselements zu einem zweiten Ende des Basiselements, das gegenüberliegend zu dem ersten Ende des Basiselements ist, erstreckt,
der erste Verbindungsteil (541_1) mit dem Basiselement (543, 643) an seinem ersten Ende verbunden ist, und/oder
der zweite Verbindungsteil (541_2) mit dem Basiselement (543, 643) an seinem zweiten Ende verbunden ist.

13. Anordnung nach Anspruch 12, wobei ein Holm (508) aus dem flachen Dach in Richtung auf das Innere des ersten Teils (502) der Abdeckung hervorsteht und mit einem Teil der oberen Oberfläche des Substrats (501) in Kontakt ist.

14. Anordnung nach einem der Ansprüche 1 bis 13, wobei das Substrat (501) eine Halbleiterschaltung aufweist.

15. Anordnung nach einem der Ansprüche 1 bis 14, wobei die Kante (647) der unteren Oberfläche des Basiselements (643), die dem ersten Teil (502) der Abdeckung am nächsten liegt, mit der oberen Oberfläche der Wärmesenke (501) in Kontakt ist.

## Revendications

1. Assemblage pour refroidissement d'un module d'alimentation, incluant :
un dissipateur thermique (510) avec un trou fileté (511) formé sur sa surface supérieure ;
un module d'alimentation (600) installé sur la surface supérieure du dissipateur thermique (510) ; et
une vis (520) ;
dans lequel le module d'alimentation (600) comprend :
un substrat (501) incluant un circuit électrique ;
un capot formé dans une même pièce, incluant une première partie (502) et une deuxième partie,
dans lequel la première partie (502) couvre au moins une partie du substrat (501),
la deuxième partie est connectée à la première partie (502) et disposée dans une zone qui ne se superpose pas au substrat (501),
la deuxième partie du capot inclut une partie inférieure présentant une base (643) avec une surface supérieure et une surface inférieure,
la base (643) inclut un trou traversant (506) qui est dirigé depuis la surface supérieure de la base (643) vers la surface inférieure de la base,
la vis (520) traverse le trou traversant (506) de la base (643) et est vissée dans le trou fileté (511) du dissipateur thermique (510), de sorte que la force de vissage descendante appliquée par la vis (520) sur la base (643) exerce une force de pression sur le substrat et
garantit un contact thermique entre le substrat (501) et le dissipateur thermique (510), et
la surface inférieure du substrat (501) est en contact avec la surface supérieure du dissipateur thermique (510),
**caractérisé en ce que**
une partie de la surface supérieure du substrat (501) adhère à une partie inférieure de la première partie (502) du capot au moyen d'une colle flexible,
la base (643) inclut une protrusion (646) sur sa surface inférieure,
le trou traversant (506) est disposé entre la protrusion (646) et la première partie (502) du capot,
la protrusion (646) sur la surface inférieure de la base (643) est en contact avec la surface supérieure du dissipateur thermique (510),
la deuxième partie du capot inclut un pont (534_1) connectant une portion supérieure de la deuxième partie du capot et une portion supérieure de la première partie (502) du capot, et la vis (520) traversant le trou traversant (506) et vissée dans le trou fileté (511) est la vis unique qui fixe le module d'alimentation (500) au dissipateur thermique (510).

2. Assemblage pour refroidissement d'un module d'alimentation, incluant :
un dissipateur thermique (510) avec un trou fileté (511) formé sur sa surface supérieure ;
un module d'alimentation fourni sur la surface supérieure du dissipateur thermique (510) ; et
une vis (520) ;
dans lequel le module d'alimentation (500) comprend :
un substrat (501) incluant un circuit électrique ;
un capot formé dans une même pièce, incluant une première partie (502) et une deuxième partie,
dans lequel la première partie (502) couvre au moins une partie du substrat (501),
la deuxième partie est connectée à la première partie (502) et disposée dans une zone qui ne se superpose pas au substrat (501),
la deuxième partie du capot inclut une partie inférieure présentant une base (543) avec une surface supérieure et une surface inférieure,
la base (543) inclut un trou traversant (506) qui est dirigé depuis la surface supérieure de la base (543) vers la surface inférieure de la base,
la vis (520) traverse le trou traversant (506) de la base (543) et est vissée dans le trou fileté (511) du dissipateur thermique (510), de sorte que la force de vissage descendante appliquée par la vis (520) sur la base (543) exerce une force de pression sur le substrat et garantit un contact thermique entre le substrat (501) et le dissipateur thermique (510), et
la surface inférieure du substrat (501) est en contact avec la surface supérieure du dissipateur thermique (510),
**caractérisé en ce que**
une partie de la surface supérieure du substrat (501) adhère à une partie inférieure de la première partie (502) du capot au moyen d'une colle flexible,
la surface inférieure de la base (543) est régulière et inclinée vers une portion supérieure de la première partie (502) du capot,
le trou traversant (506) est disposé entre la première partie (502) du capot et l'arête (544) de la surface inférieure de la base (543), qui est plus distante de la première partie (502) du capot, l'arête (544) de la surface inférieure de la base (543), qui est plus distante de la première partie (502) du capot, est en contact avec la surface supérieure du dissipateur thermique (510),
la deuxième partie du capot inclut un pont (534_1) connectant une portion supérieure de la deuxième partie du capot et une portion supérieure de la première partie (502) du capot, et
la vis (520) traversant le trou traversant (506) et vissée dans le trou fileté (511) est la vis unique qui fixe le module d'alimentation (500) au dissipateur thermique (510).

3. L'assemblage conformément à la revendication 2, dans lequel la hauteur de la surface latérale de la base (543), qui est plus éloignée de la première partie (502) du capot, est supérieure à la hauteur de la surface latérale de la base (543), qui est la plus proche de la première partie (502) du capot.

4. L'assemblage conformément à la revendication 1, dans lequel la surface supérieure de la base (543, 643) est régulière et parallèle à la surface inférieure de la base.

5. L'assemblage conformément à l'une quelconque des revendications 1 à 4, dans lequel la surface inférieure du substrat (501) et l'extrémité inférieure de la protrusion (646) présente sur la surface inférieure de la base (643) sont coplanaires, ou
la surface inférieure du substrat (501) et l'arête (544) de la surface inférieure de la base (543), qui est plus distante de la première partie (502) du capot, sont coplanaires.

6. L'assemblage conformément à l'une quelconque des revendications 1 à 5, dans lequel une cavité (535) est formée entre la première partie (502) du capot et la deuxième partie du capot.

7. L'assemblage conformément à l'une quelconque des revendications 1 à 6, dans lequel le substrat (501) est un substrat de cuivre à liaison directe (DBC, Direct Bonded Copper).

8. L'assemblage conformément à l'une quelconque des revendications 1 à 7, dans lequel la portion inférieure de la première partie (502) du capot inclut un contour, et
une partie de la surface supérieure du substrat (501) adhère à une surface inférieure du contour.

9. L'assemblage conformément à la revendication 8, dans lequel le contour comprend une feuillure (509), une partie de la surface supérieure du substrat (501) adhère à un côté de la feuillure (509) et la surface inférieure du substrat (501) déborde depuis la surface inférieure de la feuillure (509).

10. L'assemblage conformément à l'une quelconque des revendications 1 à 9, dans lequel le substrat (501) présente une forme substantiellement rectangulaire,
la première partie (502) du capot présente substantiellement la forme d'un parallélépipède rectangle et comprend quatre parois latérales et un plafond plat disposé au-dessus du substrat (501),
le contour de la première partie (502) du capot est formé par les extrémités inférieures des quatre parois latérales,
la partie de la surface supérieure du substrat (501) qui adhère à une surface inférieure du contour est une aire périphérique de la surface supérieure du substrat,
la protrusion (646) présente sur la surface inférieure de la base ou l'arête (544) de la surface inférieure de la base (543), qui est plus distante de la première partie (502) du capot, est linéaire, parallèle à et la plus proche d'une première paroi latérale (536) des quatre parois latérales de la première partie (502) du capot,
la deuxième partie du capot inclut une première pièce de connexion (541_1) et une deuxième pièce de connexion (541_2) connectant la base (543, 643) à la première partie (502) du capot,
la première pièce de connexion (541_1) et la deuxième pièce de connexion (541_2) sont connectées à la première paroi latérale (536), et
le trou traversant (506) est disposé entre la première pièce de connexion (541_1) et la deuxième pièce de connexion (541_2).

11. L'assemblage conformément à la revendication 10, dans lequel la première pièce de connexion (541_1) inclut un premier pont (534_1) connectant la première pièce de connexion (541_1) à la première paroi latérale (536), de sorte qu'une première cavité (535) est formée entre la première pièce de connexion (541_1) et la première paroi latérale (536), et/ou
la deuxième pièce de connexion (541_2) inclut un deuxième pont (534_2) connectant la deuxième pièce de connexion (541_2) à la première paroi latérale (536), de sorte qu'une deuxième cavité est formée entre la deuxième pièce de connexion (541_2) et la première paroi latérale (536).

12. L'assemblage conformément à la revendication 10 ou 11, dans lequel la protrusion (646) présente sur la surface inférieure de la base (643) ou l'arête (544) de la surface inférieure de la base (543), qui est plus distante de la première partie (502) du capot, s'étend depuis une première extrémité de la base vers une deuxième extrémité de la base, qui est opposée à la première extrémité de la base,
la première pièce de connexion (541_1) est connectée à la base (543, 643) à sa première extrémité, et/ou
la deuxième pièce de connexion (541_2) est connectée à la base (543, 643) à sa deuxième extrémité.

13. L'assemblage conformément à la revendication 12, dans lequel une colonne (508) se projette depuis le plafond plat vers l'intérieur de la première partie (502) du capot et entre en contact avec une partie de la surface supérieure du substrat (501).

14. L'assemblage conformément à l'une quelconque des revendications 1 à 13, dans lequel le substrat (501) inclut un circuit de semiconducteurs.

15. L'assemblage conformément à l'une quelconque des revendications 1 à 14, dans lequel l'arête (647) de la surface inférieure de la base (643) qui est la plus proche de la première partie (502) du capot entre en contact avec la surface supérieure du dissipateur thermique (501).
